# EUROPÄISCHE PATENTANMELDUNG

(11) **EP 1 791 044 A1**
(43) Veröffentlichungstag der Anmeldung: **30.05.2007**
(21) Anmeldenummer: 06023895.3
(22) Anmeldetag: 17.11.2006
(51) Int. Cl.: G04G 5/00, H03K 5/08, H03M 1/10

(54) **Funkuhr und Verfahren zur Gewinnung von Zeitinformationen**

(30) Priorität: 26.11.2005 DE 102005056483
(71) Anmelder: ATMEL Germany GmbH, 74072 Heilbronn (DE)
(72) Erfinder: Häfner, Horst, 74080 Heilbronn (DE)

(57) **Zusammenfassung**

Bei einem Verfahren zur Gewinnung von Zeitinformationen aus einem empfangenen, amplitudenmodulierten Zeitzeichensignal wird das Zeitzeichensignal demoduliert, das erhaltene Analogsignal (AS) mittels eines Komparators digitalisiert und das erhaltene Digitalsignal (DS) zur Gewinnung der Zeitinformationen ausgewertet. Vorliegend ist darüber hinaus vorgesehen, dass ein Kennwert der zeitlichen Dauer (T) wenigstens einer Signalphase eines bestimmten Signalpegels (Low) des Digitalsignals () mit einem Sollwert (SW) vergleichen wird und dass eine Komparatorschwelle (KS) des Komparators in Abhängigkeit von einem Ergebnis des Vergleichs verändert wird, sodass die zeitliche Dauer (T) zumindest der betreffenden Signalphase (Low) des Digitalsignals (DS) sich an den Sollwert (SW) annähert. Auf diese Weise wird erfindungsgemäß bei einem Empfänger zum Empfang von Zeitzeichensignalen eine verbesserte Systemempfindlichkeit erreicht. Insbesondere wird dabei auch die Fehlerhäufigkeit durch verfälschte lmpulslängen reduziert, und gestörte Empfangssignale werden aufgrund ihrer zeilichen Abweichung vom jeweiligen Sollwert besser als solche erkannt. Außerdem ermöglicht der erfindungsgemäße Ansatz in einfacher Weise eine Kompensation von Fertigungstoleranzen der verschiedenen Bausteine der beschriebenen Schaltungsanordnung.

## Beschreibung

Die Erfindung betrifft ein Verfahren zur Gewinnung von Zeitinformationen aus einem empfangenen, amplitudenmodulierten Zeitzeichensignal, wobei das Zeitzeichensignal demoduliert, das erhaltene Analogsignal mittels eines Komparators digitalisiert und das erhaltene Digitalsignal zur Gewinnung der Zeitinformationen ausgewertet wird.

Die Erfindung betrifft ferner eine Schaltungsanordnung zum Empfangen und zur Gewinnung von Zeitinformationen aus von einem Zeitzeichensender gesendeten, amplitudenmodulierten Zeitzeichensignalen, insbesondere zur Durchführung des erfindungsgemäßen Verfahrens, mit einem Demodulator zum Demodulieren des Zeitzeichensignals und zum Erzeugen eines Analogsignals aus dem Zeitzeichensignal, einem Komparator zum Digitalisieren des erhaltenen Analogsignals und einer Auswerteeinheit für das erhaltene Digitalsignal zur Gewinnung der Zeitinformationen, sowie eine elektronische Uhr.

Die funkgesteuerte Übertragung von Zeitinformationen erfolgt mittels so genannter Zeitzeichensignale, die von entsprechenden Sendern - nachfolgend kurz als Zeitzeichensender bezeichnet - ausgesendet werden. Unter einem Zeitzeichensignal soll ein Sendersignal kurzer Dauer verstanden werden, dem die Aufgabe zukommt, die von einem Sender bereitgestellte Zeitreferenz zu übertragen. Es handelt sich dabei um eine Modulationsschwingung mit meist mehreren Zeitmarken, die demoduliert lediglich einen Impuls darstellen, der die ausgesendete Zeitreferenz mit einer bestimmten Unsicherheit reproduziert.

Die deutsche Langwellensendestation DCF-77 sendet gesteuert durch Atomuhren im Dauerbetrieb amplitudenmodulierte Langwellenzeitsignale nach der amtlichen Atomzeitskala MEZ mit einer Leistung von 50 KW auf der Frequenz 77,5 kHz. In anderen Ländern existieren ähnliche Sender, die Zeitinformationen auf einer Langwellenfrequenz im Bereich zwischen 40 bis 120 kHz aussenden. Alle genannten Länder verwenden für die Übertragung der Zeitinformationen jeweils ein sog. Telegramm, das genau eine Minute lang ist.

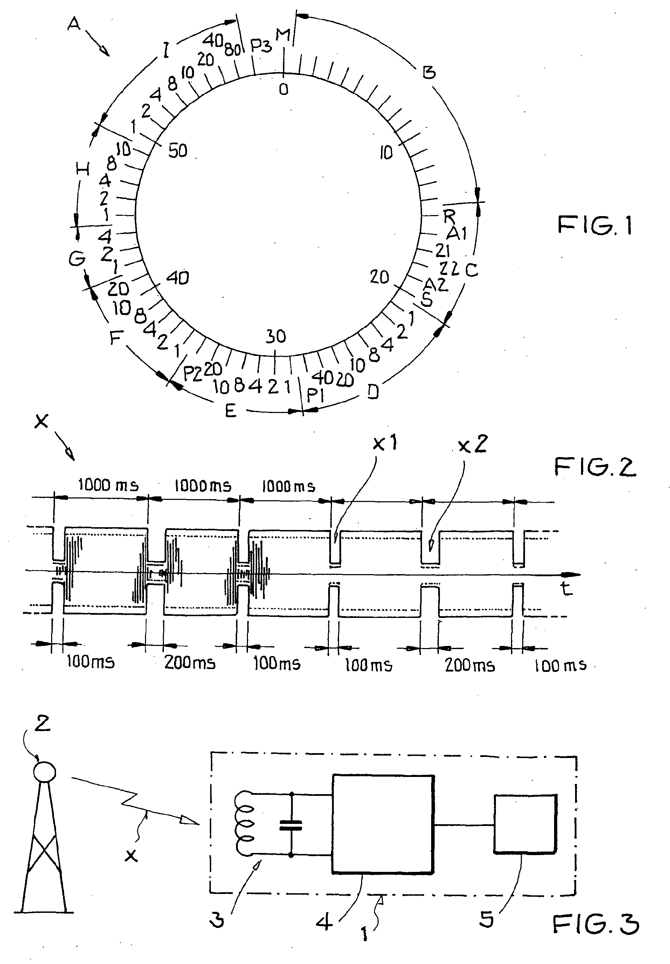

Die Fig. 1 zeigt das mit Bezugszeichen A bezeichnete Codierungsschema (Telegramm) der codierten Zeitinformation im Falle des deutschen Zeitzeichensenders DCF-77. Das Codierungsschema besteht vorliegend aus 59 Bits, wobei jeweils 1 Bit einer Sekunde des Zeitrahmens entspricht. Im Verlauf einer Minute kann damit ein so genanntes Zeitzeichen-Telegramm übertragen werden, das in binär verschlüsselter Form insbesondere eine Information zu Zeit und Datum enthält. Die ersten 15 Bits B enthalten eine allgemeine Codierung, die zum Beispiel Betriebsinformationen beinhaltet. Die nächsten fünf Bits C enthalten allgemeine Informationen. So bezeichnet R das Antennenbit, A1 bezeichnet ein Ankündigungsbit für den Übergang der mitteleuropäischen Zeit (MEZ) zur mitteleuropäischen Sommerzeit (MESZ) und zurück, Z1 und Z2 bezeichnen Zonenzeitbits, A2 bezeichnet ein Ankündigungsbit für eine Schaltsekunde und S bezeichnet ein Startbit der codierten Zeitinformationen. Ab dem 21. Bit bis zum 60. Bit werden die Zeit- und Datumsinformationen im BCD-Code übertragen, wobei die Daten jeweils für die darauf folgende Minute gelten. Dabei enthalten die Bits im Bereich D Informationen über die Minute, im Bereich E Informationen über die Stunde, im Bereich F Informationen über den Kalendertag, im Bereich G Informationen über den Tag der Woche, im Bereich H Informationen über den Monat und im Bereich I Informationen über das Kalenderjahr. Diese Informationen liegen bitweise in codierter Form vor. Jeweils am Ende der Bereiche D, E und I sind so genannte Prüf-Bits P1 P2, P3 vorgesehen. Das sechzigste Bit des Telegramms ist nicht belegt und dient dem Zweck, den Beginn des nächsten Rahmens anzuzeigen. M bezeichnet die Minutenmarke und damit den Beginn des Zeitzeichentelegramms.

Die Struktur und die Bit-Belegung des in Fig. 1 dargestellten Codierungsschemas zur Übermittlung von Zeitzeichensignalen ist allgemein bekannt und beispielsweise in dem Artikel von Peter Hetzel, "Zeitinformation und Normalfrequenz", in Telekom Praxis, Band 1, 1993 beschrieben.

Die Übertragung der Zeitzeicheninformation erfolgt gemäß der Fig. 2 amplitudenmoduliert mittels einzelner Sekundenmarken. Die Modulation besteht aus einer Absenkung X1, X2 (oder einer Anhebung) des Trägersignals X zu Beginn jeder Sekunde, wobei zu Beginn jeder Sekunde - mit Ausnahme der neunundfünfzigsten Sekunde jeder Minute - im Falle eines vom DCF-77 Sender ausgesendeten Zeitzeichensignals die Trägeramplitude für die Dauer von 0,1 Sekunden X1 oder für die Dauer von 0,2 Sekunden X2 auf etwa 25% der Amplitude abgesenkt wird. Diese Absenkungen X1, X2 unterschiedlicher Dauer definieren jeweils Sekundenmarken bzw. Datenbits in decodierter Form. Diese unterschiedliche Dauer der Sekundenmarken dient der binären Codierung von Uhrzeit und Datum, wobei Sekundenmarken mit einer Dauer von 0,1 Sekunden X1 einer binären "0" und solche mit einer Dauer von 0,2 Sekunden X2 einer binären "1" entsprechen. Durch das Fehlen der sechzigsten Sekundenmarke wird die nächstfolgende Minutenmarke angekündigt. In Kombination mit der jeweiligen Sekunde ist dann eine Auswertung der vom Zeitzeichensender gesendeten Zeitinformation möglich. Figur 2 zeigt anhand eines Beispiels einen Ausschnitt eines solchen amplitudenmodulierten Zeitzeichensignals X. Die Auswertung der genauen Zeit und des genauen Datums ist allerdings nur dann möglich, wenn die 59 Sekundenbits einer Minute eindeutig erkannt werden und somit jedem dieser Sekundenmarken jeweils eindeutig eine "0" oder eine "1" zugeordnet werden kann.

In anderen Ländern, wie Großbritannien, Japan oder den USA, erfolgt die Modulation ebenfalls durch Absenkungen bzw. Anhebungen der Amplitude des Trägersignals X, allerdings variieren die Sekundenmarken und damit die zeitlichen Dauern der Absenkungen bzw. Anhebungen X1, X2 hierbei mehr oder weniger und und betragen je nach Senderprotokoll zwischen 100 und 800 ms. Im amerikanischen (WWVB) und im japanischen Protokoll (JJY40 und JJY60) betragen die zeitlichen Anteile der Signalabsenkungen speziell 50 bzw 80% einer vollen Sekunde. Auch der Pegel der Absenkung ist bei allen Protokollen unterschiedlich und reicht von einer vollständigen Absenkung bis auf einen Nullpegel in Großbritannien (MSF) bis zu einer Absenkung von nur 32% der Nominalamplitude beim amerikanischen Sender (WWVB).

Zum allgemeinen Hintergrund von Funkuhren und Schaltungsanordnungen zum Empfang von Zeitzeichensignalen wird auf die DE 198 08 431 A1, die DE 43 19 946 A1, die DE 43 04 321 C2, die DE 42 37 112 AI und die DE 42 33 126 A1 verwiesen. Hinsichtlich der Informationsgewinnung und -verarbeitung von Zeitinformationen aus Zeitzeichensignalen wird auf die DE 195 14 031 C2, die DE 37 33 965 C2 und die EP 042 913 B1 verwiesen.

Vorbekannte Schaltungsanordnungen der eingangs genannten Art weisen regelmäßig einen (Ausgangs-)Komparator auf, der den Signalpegel des durch Demodulation gewonnenen, gleichgerichteten Analogsignals zum Zwecke der Digitalisierung mit einem Referenzwert, der Komparatorschwelle, vergleicht und als Ergebnis entweder ein Low-Pegel-Signal (logische "0") oder ein High-Pegel-Signal (logische "1 ") liefert, wenn der analoge Signalpegel unterhalb bzw. oberhalb der Komparatorschwelle liegt. Eine demgegenüber invertierte Logik ist ebenfalls möglich. Da das gleichgerichtete Signal jedoch nur langsam der Eingangsamplitude des eigentlichen Eingangssignales folgt und die steigenden und fallenden Flanken oft nicht die gleiche Steilheit besitzen, beeinflußt die Lage der Komparatorschwelle in hohem Maße die zeitliche Dauer der Low-Phase ("0") bzw High-Phase ("1") des erzeugten Digitalsignals. Insbesondere bei niedrigen Eingangspegeln, die stets mit Rauschen überlagert sind, sind die Flanken - insbesondere die fallenden Flanken - des analogen Signals relativ flach und die absoluten Spannungsänderungen relativ gering, sodass die Komparatorschwelle einen besonders starken Einfluß auf die zeitlichen Dauern der Low- und High-Phasen des Digitalsignals hat.

Die Lage der Schwelle des Ausgangskomperators spielt demnach eine entscheidende Rolle bei der Umwandlung des gleichgerichteten und demodulierten Analogsignals in ein digitales Signal, anhand dessen - wie oben beschrieben - die Absenkungen des amplitudenmodelierten Zeitzeichensignals bzw. deren zeitliche Dauern zwecks Gewinnung der darin enthaltenen Zeitinformationen durch die Auswerteeinheit bestimmt werden. Heutzutage ist die Komparatorschwelle für das analoge decodierte Zeitsignal (TCO) in nachteiliger Weise entweder fest eingestellt oder analog über der Eingangsamplitude geregelt. Dabei erscheint es sinnvoll, die Komparatorschwelle bei kleinen Eingangspegeln verstärkt einem Maximalpegel des Analogsignals anzunähern, und sie bei hohem Eingangspegeln entsprechend abzusenken. Dieser Ansatz wurde bereits bei einigen Typen von integrierten Empfängerschaltungen realisiert. Allerdings muß eine derartige Nachführung der Komparatorschwelle relativ moderat ausgelegt werden, da keinerlei Rückkopplung vorgesehen ist. Zudem ist diese Regelung als solche ebenfalls als nachteilig anzusehen, da hierbei nur die Signalamplitude, nicht jedoch das Signal selbst (die Signalqualität) bewertet wird, was zu einem fehlerhaften Empfang der Zeitinformationen führen kann. "Fehlerhaft" bedeutet, dass während der Dauer eines empfangenen Minutenprotokolls binäre Fehlentscheidungen getroffen werden, die zu einer fehlerhaften Auswertung von zumindest einem Datenbit des Minutenprotokolls führen. Die aus dem empfangenen Zeitzeichensignal abgeleitete Zeit wäre dann nicht mehr korrekt.

Der vorliegenden Erfindung liegt die Aufgabe zugrunde, ein Verfahren und eine Schaltungsanordnung der eingangs genannten Art dahingehend weiter zu entwickeln, dass bei einem Empfänger zum Empfang von Zeitzeichensignalen eine verbesserte Systemempfindlichkeit erreicht wird. Insbesondere soll auch die Fehlerhäufigkeit durch verfälschte Impulslängen reduziert und gestörte Empfangssignale besser erkannt werden. Darüber hinaus soll einfache Anpassung an unterschiedliche Protokolle (Länder) möglich sein.

Die Aufgabe wird bei einem Verfahren der eingangs genannten Art dadurch gelöst, dass ein Kennwert der zeitlichen Dauer wenigstens einer Signalphase eines bestimmten Signalpegels des Digitalsignals mit einem Sollwert verglichen wird und dass eine Komparatorschwelle des Komparators in Abhängigkeit von einem Ergebnis des Vergleichs verändert wird, sodass die zeitliche Dauer zumindest der betreffenden Signalphase des Digitalsignals sich an den Sollwert annähert. Dabei kann es sich bei dem Kennwert in einfachster Weise insbesondere um die Dauer der Signalphase selbst handeln. Es ist jedoch auch die Verwendung abgeleiteter Kennwerte möglich, wie weiter unten noch ausgeführt wird.

Bei einer Schaltungsanordnung der eingangs genannten Art sind zur Lösung der Aufgabe vorgesehen: eine Speichereinrichtung, in der zumindest ein Sollwert für die zeitliche Dauer wenigstens einer Signalphase des Zeitzeichensignals hinterlegt ist, eine Vergleichseinrichtung in Wirkverbindung mit der Speichereinrichtung, die zum Vergleichen eines Kennwerts der zeitlichen Dauer wenigstens einer Signalphase eines bestimmten Signalpegels des Digitalsignals mit dem Sollwert ausgebildet ist, und eine Änderungseinrichtung in Wirkverbindung mit der Vergleichseinrichtung, die zum Verändern einer Komparatorschwelle des Komparators in Abhängigkeit von einem Ergebnis des Vergleichs in der Vergleichseinrichtung ausgebildet ist, sodass die zeitliche Dauer zumindest der betreffenden Signalphase des Digitalsignals an den Sollwert anpassbar ist.

Weiterhin wird die Aufgabe auch gelöst von einer Funkuhr, die eine erfindungsgemäße Schaltungsanordnung aufweist.

Der Erfindung basiert demnach auf der grundlegenden ldee, dass über eine Regelung der Komparatorschwelle und durch einen Vergleich zeitlicher Dauern des Digitalsignals mit abgespeicherten Sollwerten die Längen der zeitrelevanten Signalimpulse (Absenkungen oder Anhebungen) optimiert werden. Abweichend von den bisherigen Lösungsansätzen ist es dabei erfindungsgemäß wesentlich effektiver, die Komparatorschwelle so zu regeln, dass die Schwellenänderung über die Länge des digitalisierten Signals, d.h. die zeitliche Dauer bestimmter Signalphasen dieses Signals bestimmt wird. Beispielsweise lässt sich im Falle des deutschen Zeitzeichensenders und bei Empfang von Absenkungen einer zeitlichen Dauer von nur 80 ms an Stelle der zu erwartenden 100 ms durch Anheben der Komparatorschwelle (verringerter Hub) eine Verlängerung der Low-Phasen des Digitalsignals erzielen. Umgekehrt wird erfindungsgemäß bei Empfang von Absenkungen mit einer zeitlichen Dauer von z.B. 120 ms an Stelle der zu erwartenden 100 ms durch Absenken der Komparatorschwelle (vergrößerter Hub) eine Verkürzung der Low-Phasen des Digitalsignals erzielt.

Demnach gilt allgemein: Je höher der Hub, desto kürzer die Low-Phase. Gleichzeitg steigt aber auch die Sicherheit an, dass ein Störimpuls, der sich praktisch immer durch eine Erhöhung der Amplitude bemerkbar macht, zu keiner fehlerhaften Veränderung der Komparatorschwelle führt.

In einer bevorzugten Weiterbildung des erfindungsgemäßen Verfahrens ist nach dem Vorstehenden vorgesehen, dass speziell die zeitliche Dauer einer Low-Phase des Digitalsignals mit einem entsprechenden Sollwert, d.h. der Dauer einer Amplitudenabsenkung des Zeitzeichensignals verglichen wird. Entsprechend sieht eine Weiterbildung der erfindungsgemäßen Schaltungsanordnung vor, dass der Sollwert die zeitliche Dauer einer Amplitudenabsenkung des Zeitzeichensignals ist. Prinzipiell wäre es jedoch auch möglich, die Schwellenanpassung anhand eines Vergleichs von High-Phasen des Digitalsignals mit entsprechenden Amplitudenmaxima bzw. -anhebungen des Zeitzeichensignals durchzuführen.

Gemäß einer anderen Weiterentwicklung des erfindungsgemäßen Verfahrens ist vorgesehen, dass die Veränderung der Komparatorschwelle stufenweise erfolgt, was sich in einfacher Weise durch die Realisierung der Komparatorschwelle als Kombination aus einer Anzahl von Bits erreichen lässt. Eine entsprechende Ausgestaltung der erfindungsgemäßen Schaltungsanordnung sieht vor, dass die Änderungseinrichtung zum stufenweisen Verändern der Komparatorschwelle ausgebildet ist. So lassen sich durch Kombination von zwei Bits bis zu vier unterschiedliche Schwellenwerte realisieren. Allerdings bringen mehr als acht Schwellenwerte (drei Bits) in der praktischen Umsetzung kaum noch messbare Verbesserungen.

Vorteilhafter Weise kann darüber hinaus vorgesehen sein, dass für den Vergleich ein Mittelwert aus einer Mehrzahl von zeitlichen Dauern der betreffenden Signalphase des Digitalsignals - vorzugsweise über eine gesamte zeitliche Dauer von mehreren Sekunden, entsprechend einem Empfang mehrerer Sekunden-Bits eines Zeitrahmens - gebildet wird, damit es nicht zu einem zu häufigen Umschalten des Komparators kommt. Ein solcher Mittelwert stellt somit ein weiteres Beispiel für einen Kennwert der zeitlichen Dauer einer Signalphase dar. Zu diesem Zweck weist die erfindungsgemäße Schaltungsanordnung im Zuge einer besonders vorteilhaften Weiterbildung eine Recheneinheit in Wirkverbindung mit der Vergleichseinrichtung auf, die zum Bestimmen des Mittelwerts aus einer Anzahl von zeitlichen Dauern der betreffenden Signalphase des Digitalsignals und zum Bereitstellen des Mittelwerts in der Vergleichseinrichtung als Kennwert ausgebildet ist.

Nach den obigen Ausführungen unterscheiden sich die Zeitzeichensender verschiedener Länder hinsichtlich der Dauer und des Pegels ihrer Signalabsenkungen. Auch diese beiden Parameter haben einen Einfluß auf die entsprechende Dauer der Absenkung (Low-Phase) des erzeugten Digitalsignals. Insbesondere bei Empfängern für verschiedene Protokolle ist es umso wichtiger, eine jeweils optimale Komparatorschwelle nutzen zu können. Eine Umschaltung ist deshalb gerade hier von besonderer Bedeutung, wobei in Weiterbildung des erfindungsgemäßen Verfahrens vorzugsweise der jeweilige Sollwert in Abhängigkeit von einem das Zeitzeichensignal aussendenden Zeitzeichensender bestimmt wird. Entsprechend sieht eine bevorzugte Ausgestaltung der erfindungsgemäßen Schaltungsanordnung vor, dass die Auswerteeinheit zum Erkennen des Zeitzeichensenders aus einer Mehrzahl von Zeitzeichensendern ausgebildet ist und dass in Abhängigkeit von dem erkannten Zeitzeichensender ein entsprechender Sollwert aus der Speichereinrichtung in der Vergleichseinrichtung bereitstellbar ist. Eine solche Erkennung von Zeitzeichensendern ist in der deutschen Patentanmeldung mit dem amtlichen Aktenzeichen 10357201.5 beschrieben, deren Offenbarungsgehalt insoweit durch Bezugnahme mit in die vorliegende Anmeldung aufgenommen wird.

Weitere Vorteile und Eigenschaften der Erfindung ergeben sich aus der nachfolgenden Beschreibung eines Ausführungsbeispiels anhand der Zeichungen. Es zeigt/zeigen:
- Fig. 1: das Codierungsschema (Zeitzeichentelegramm) einer von dem Zeitzeichensender DCF-77 gesendeten codierten Zeitinformation;
- Fig. 2: einen Ausschnitt eines idealisierten bekannten DCF-77 Zeitzeichen-Sendesignals mit mehreren Sekundenimpulsen (Sekundenmarken);
- Fig. 3: ein detaillierteres schematisches Blockschaltbild einer Funkuhr mit einer erfindungsgemäßen Schaltungsanordung;
- Fig. 4: ein schematisches Blockschaltbild der erfindungsgemäßen Schaltungsanordung aus Fig. 3; und
- Fig. 5a,b: Signalverläufe jeweils eines analogen Eingangssignals und eines entsprechenden digitalisierten Ausgangssignals am Komparator der erfindungsgemäßen Schaltungsanordnung.

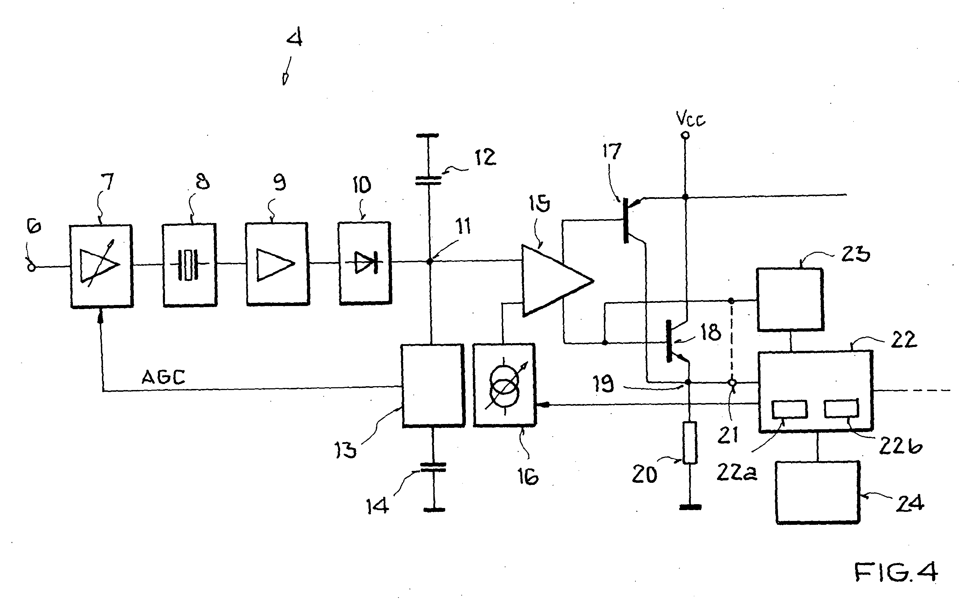

Die Fig. 3 zeigt ein stark vereinfachtes schematisches Blockschaltbild einer Funkuhr 1. Die Funkuhr 1 empfängt Zeitzeichensignale X (vgl. Fig. 1, 2) von einem Zeitzeichensender 2. Dazu weist die Funkuhr 1 eine Empfangsantenne 3 auf, der eine erfindungsgemäße Schaltungsanordnung 4 nachgeschaltet ist, die nachfolgend anhand der Fig. 4 noch detailliert erläutert wird. Der Schaltungsanordnung 4 nachgeschaltet weist die Funkuhr 1 weiterhin zumindest eine Anzeigeeinrichtung 5 auf, durch die eine aus dem Zeitzeichensignal X entnommene Zeitinformation für einen Verwender der Funkuhr 1 zur Anzeige gebracht wird.

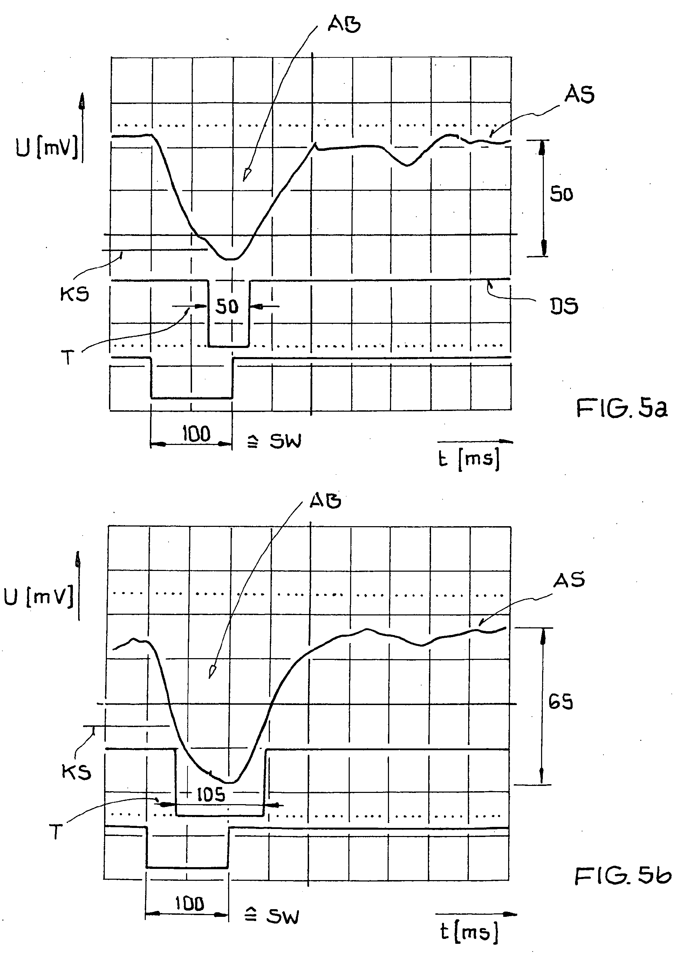

Die Fig. 4 zeigt ein detaillierteres schematisches Blockschaltbild der erfindungsgemäßen Schaltungsanordung 4 aus Fig. 3, welche zum Empfangen und Verarbeiten des Zeitzeichensignals X (Fig. 3) des deutschen Senders DCF-77 ausgebildet ist. Die Schaltungsanordnung 4 besitzt zunächst einen Eingang 6 für das empfangenene Zeitzeichensignal X, welches hier mit einer Signalstärke von typischer Weise etwa 0,5 µV anliegt. Der Eingang 6 ist zur Verstärkung des Eingangssignals mit einem Regelverstärker 7 verbunden. Ein weiterer Eingang des Regelverstärkers 7 dient der Zuführung eines Verstärkungs-Regelsignals AGC (Automatic Gain Control). Dem Regelverstärker 7 ist ausgangsseitig ein Filter 8 nachgeschaltet, das vorzugsweise piezoelektrisch ausgebildet und auf die Frequenz des Zeitzeichensenders 2 (Fig. 3) abgestimmt ist. Wenn die Funkuhr zum Empfang mehrerer unterschiedlicher Zeitzeichensender 2 ausgebildet ist, kommt hierbei vorzugsweise ein entsprechend umschaltbares Filter 8 zum Einsatz. Über das Filter 8 ist der Ausgang des Regelverstärkers 7 mit dem Eingang eines Nachverstärkers 9 verbunden. Diesem ist ein Gleichrichter 10, beispielsweise eine Diodenschaltung, nachgeschaltet, sodass an einem hinter dem Gleichrichter 10 liegenden Knoten 11, der mit einem ersten Kondensator 12 verbunden ist, ein Analogsignal AS (Fig. 5a,b) anliegt, welches sich nach Gleichrichtung und Demodulation des ursprünglich empfangenen Zeitzeichensignals X ergibt. Zu diesem Zweck besitzt der Kondensator 12 im Zuge des vorliegenden Ausführungsbeispiels insbesondere eine relativ geringe Kapazität von etwa 22 nF und dient so einer PWM-Detektion hinsichtlich der in dem Zeitzeichensignal X enthaltenen codierten Zeitinformationen. Die Signalstärke des verstärkten Analogsignals AS am Knoten 11 beträgt größenordnungsmäßig etwa 200 mV. Ebenfalls in Verbindung mit dem Knoten 11 weist die erfindungsgemäße Schaltungsanordnung 4 einen Signalspitzen-Detektor 13 auf, dem ein zweiter, relativ großer Kondensator 14 mit einer Kapazität von beispielsweise 2,2 µF nachgeschaltet ist. Dieser Kondensator 14 dient der AGC-Regelung und bewirkt in Verbindung mit dem Signalspitzen-Detektor 13 das weiter oben bereits erwähnte Verstärkungs-Regelsignal AGC für den Regelverstärker 7, was dem Fachmann an sich bekannt ist.

Weiterhin ist der Knoten 11 mit dem ersten Eingang eines Komparators 15 verbunden, an dessen anderen Eingang ein regelbare Spannungsquelle 16 angeschlossen ist, die eine veränderbare Referenzspannung zum variablen Einstellen der Schwelle des Komparators 15 liefert. Der Ausgang des Komparators 15 ist gemäß dem Ausführungsbeispiel der Fig. 4 zunächst mit zwei Schaltmitteln in Form zweier Bipolar-Transistoren 17 bzw. 18 derart verbunden, dass er jeweils mit dem Gate des betreffenden Transistors 17, 18 in Verbindung steht. Der Transistor 17 ist als pnp-Transistor und der Transistor 18 als npn-Transistor ausgebildet, wobei ersterer mit seinem Emitter und letzterer mit seinem Kollektor an eine Betriebsspannung VCC angeschlossen ist. Andererseits sind die Transistoren 17 bzw. 18 mit ihrem Kollektor bzw. Emitter mit einem Knoten 19 verbunden, an den weiterhin ein Pull-down-Widerstand 20 angeschlossen ist. Auf diese Weise ergibt sich an einem Ausgang 21 der durch den Komparator 15 und die Transistoren 17, 18 gebildeten Digitalisierungsschaltung in Abhängigkeit von der Lage des Analogsignals AS bezüglich der Schwelle des Komparators 15 ein digitales Signal DS (Fig. 5a,b), welches definiert entweder einen Signalpegel entsprechend der Betriebsspannung VCC (High-Pegel, logische "1 "; sog. "active high") oder einen verschwindenden Signalpegel annimmt (Low-Pegel, logische "0"). Im Rahmen einer alternativen Ausgestaltung (nicht gezeigt) der erfindungsgemäßen Schaltungsanordung 4 ist der Ausgang des Komparators 15 direkt mit den nachfolgenden Auswerteblöcken 22, 23 (siehe unten) verbunden, sodass die in der Fig. 4 gezeigten Transistoren 17, 18 sowie der Widerstand 20 entfallen, wodurch sich ein vereinfachter und kostengünstigerer Schaltungsaufbau ergibt.

An den Ausgang 21 ist weiterhin eine digitale Auswerteeinheit 22 angeschlossen, die in an sich bekannter Weise für das Gewinnen der Zeitinformationen aus dem Digitalsignal DS zuständig ist und die weiterhin mit der Anzeigeeinheit 5 (Fig. 3) zum Anzeigen der gewonnenen Zeitinformationen in signaltechnischer Verbindung steht, was in der Fig. 4 nur andeutungsweise dargestellt ist. Erfindungsgemäß weist die Auswerteeinheit 22 noch eine Vergleichseinrichtung 22a sowie eine Recheneinheit 22b auf, die vorzugsweise programmtechnisch ausgebildet sein können und deren Funktion später noch eingehend erläutert wird. Darüber hinaus weist die erfindungsgemäße Schaltungsanordnung 4 zusätzlich einen Zähler 23 sowie eine Speichereinrichtung 24 auf, die jeweils mit der Auswerteeinheit 22 in Wirkverbindung stehen. Letztere steht darüber hinaus noch in Wirkverbindung mit der regelbaren Spannungsquelle 16, um so gemäß dem Wesen der vorliegenden Erfindung auf die Lage der Komparatorschwelle direkt Einfluß nehmen zu können, wobei die Spannungsquelle 16 erfindungsgemäß zusammen mit der Auswerteeinheit 22 als Änderungseinrichtung für die Komparatorschwelle fungiert. Der Zähler ist weiterhin entweder direkt mit dem Ausgang des Komparators 15 oder (gestrichelt gezeichnet) ebenfalls mit dem Ausgang 21 verbunden und dazu ausgebildet, in Zusammenarbeit mit der Auswerteeinheit 22 eine zeitliche Dauer von Signalphasen (High bzw. Low) des digitalisierten Signals DS zu bestimmen (s.u.). Die Speichereinrichtung 24 ist dabei insbesondere zum Speichern von Sollwerten für die zeitlichen Dauern der entsprechenden Signalphasen (Absenkungen bzw. Anhebungen X1, X2; vgl. Fig. 2) in den Zeitzeichensignalen X einer Vielzahl bekannter Zeitzeichensender ausgebildet, d.h. einer Absenkungsdauer (Low-Phase) von 100 bzw. 200 ms für den deutschen Sender DCF-77.

Wie bereits erwähnt, bewirkt die vorstehend beschriebene Schaltungsanordnung insbesondere die Verstärkung, Gleichrichtung und Demodulation des empfangenen Zeitzeichensignals X (Fig. 3). Nach der Demodulation steht am Knoten 11 (Fig. 4) ein analoges Signal AS zur Verfügung, dessen Spannung nach Maßgabe des Kondensators 12 der (modulierten) Amplitude des Zeitzeichensignals X folgt. Dieses sog. TCO-Signal wird nun mittels des Komparators 15 digitalisiert. Ein niedriger Eingangspegel des Analogsignals AS - unterhalb der mittels der regelbaren Spannungsquelle 16 über die Auswerteeinheit 12 einstellbaren Komparatorschwelle - ergibt einen Low-Pegel am Ausgang 21, ein hoher Eingangspegel entsprechend einen High-Pegel. Da jedoch das gleichgerichtete Signal AS nur langsam der Eingangsamplitude des Zeitzeichensignals folgen kann und die Signalflanken oftmals nicht die gleiche Steilheit besitzen, beeinflußt die Lage der Schwelle des Komparators 15 die Dauer der Low- bzw High-Phasen des Digitalsignals DS. Insbesondere bei niedrigen Eingangspegeln, die stets mit Rauschen überlagert sind, sind die Flanken des analogen Signales relativ flach und mit einer nur geringen absoluten Spannungsänderung verbunden, sodass die Komparatorschwelle hier einen besonders starken Einfluß auf die digitalisierten Low- und High-Phasen hat. Dieser Sachverhalt ist in den Fig. 5a,b nochmals zeichnerisch dargestellt.

Die Fig. 5a zeigt das demodulierte, gleichgerichtete analoge Signal AS am Knoten 11 (Fig. 4) vor der Digitalisierung durch den Komparator 15. Dargestellt ist die Signalspannung U in Millivolt (mV) über der Zeit t in Millisekunden (ms). Das Signal AS ist mit Rauschen überlagert und weist im Bereich AB eine Absenkung auf, die einer bestimmten Absenkung X1, X2 der Amplitude des Zeitzeichensignals X entspricht (vgl. Fig. 2), was durch die Auswerteeinheit 22 aus einem geeignet digitalisierten Signal ermittelbar sein soll. In der Fig. 5a ist weiterhin eine bestimmte eingestellte Komparatorschwelle KS des Komparators 15 dargestellt. Sobald das Analogsignal AS den zugeordneten Schwellenspannungswert unterschreitet, sinkt die Spannung am Ausgang 21 (Fig. 4) von ihrem High-Pegel-Wert auf dem Low-Pegel-Wert Null ab, um beim anschließenden erneuten Überschreiten der Komparatorschwelle KS wieder auf den Wert High-Pegel-Wert VCC anzusteigen. Der resultierende Verlauf des erhaltenen Digitalsignals mit dem Bezugszeichen DS versehen. Die zeitliche Dauer T der so entstandenen Absenkung (Low-Phase) des Digitalsignals DS wird anschließend durch den Zähler 23 (Fig. 4) quantitativ bestimmt und durch die Auswerteeinheit 22 ausgewertet, indem durch die Vergleichseinrichtung 22a ein Vergleich mit den in der Speichereinrichtung 24 abgelegten Sollwerten SW vorgenommen wird. Im Beispiel der Fig. 5a beträgt die so gefundene zeitliche Dauer T der Low-Phase lediglich etwa 50 ms, was deutlich unterhalb des Sollwerts SW = 100 ms für den deutschen Sender DCF-77 liegt. Vorzugsweise wird nun über mehrere Sekundenmarken des Zeitzeichensignals X hinweg der Mittelwert über entsprechende zeitliche Dauern T gebildet und wie vorstehend beschrieben mit dem dazu gehörigen Sollwert verglichen. Stellt die Auswerteeinheit 22 anschließend fest, dass der gemessene (Mittel-)Wert T vom Sollwert SW abweicht, so veranlasst sie die Spannungsquelle 16 (Fig. 4), durch Veränderung der Referenzspannung am Komparator 15 dessen Schwelle schritt- bzw. stufenweise herauf zu setzen, was gemäß der Darstellung in Fig. 5a eine zeitliche Verlängerung der Low-Phase zur Folge hat, bis deren zeitliche Dauer T innerhalb vorgegebener Grenzen mit dem Sollwert SW übereinstimmt. Dabei gilt allgemein: Je näher die Komparatorschwelle KS am Sollwert SW, d.h. dem im Wesentlichen konstanten oberen Pegelwert des demodulierten Signals AS liegt (geringer Hub), desto länger ist die Low-Phase des digitalisierten Signals DS. Je höher dagegen der Hub, desto kürzer ist die Low-Phase. Allerdings führt in letzterem Fall ein Störimpuls, der sich praktisch immer durch eine Erhöhung der Signalamplitude bemerkbar macht, weniger leicht zu einem falschen Umschalten des Komparators.

Die Fig. 5b zeigt entsprechend den Fall, dass die bestimmte, ggf. gemittelte zeitliche Dauer T der Low-Phase des Digitalsignals DS etwa 105-110 ms beträgt und somit nur knapp oberhalb des Sollwerts SW von 100 ms liegt. Hier ließe sich demgemäß durch leichtes Absenken der Komparatorschwelle KS eine optimale Annäherung an den Sollwert SW erreichen. Es wäre jedoch alternativ auch möglich, in einem solchen Fall aufgrund der bereits hochgradigen Übereinstimmung der beiden Zeitdauern (Ist T bzw. Soll SW) keine weitere Veränderung der Komparatorschwelle vorzunehmen, insbesondere wenn ein stufenartiges Absenken der Komparatorschwelle KS ein Unterschreiten des Sollwerts SW zur Folge hätte.

Selbstverständlich kann bezüglich der 200 ms-Low-Phase des DCF-Signals bzw. bezüglich der entsprechenden Absenkungsdauern der anderen weiter oben genannten Zeitzeichensender analog verfahren werden. Ebenso sind besondere "Anpassungsstrategien" für den Bereich zwischen den beiden zu erwartetenden, im Zeitzeichensignal enthaltenen Absenkungsdauern möglich, wenn also beispielsweise die gemessene Absenkungsdauer genau zwischen z.B. 100 und 200 ms liegt, wie etwa bei 140-160 ms. Insbesondere könnte dann durch verlängertes Abwarten bzw. eine ausgeweitete Mittelung auf eine tendenzielle weitere Vergrößerung oder Verringerung der zeitlichen Dauer der beobachteten Signalphase gewartet und die Schwellenanpassung solange hinausgezögert werden. Alternativ ist auch möglich, nur die zu kurzen Impulse der kurzen Zeitdauer und die zu langen Impulse der langen Zeitdauer für die Änderung der Schwelle zu berücksichtigen, um die zwischen diesen Impulsdauern liegenden Werte nicht falsch zu bewerten.

Auf diese Weise wird erfindungsgemäß bei einem Empfänger zum Empfang von Zeitzeichensignalen eine verbesserte Systemempfindlichkeit erreicht. Insbesondere wird dabei auch die Fehlerhäufigkeit durch verfälschte Impulslängen reduziert, und gestörte Empfangssignale werden aufgrund ihrer zeilichen Abweichung vom jeweiligen Sollwert besser als solche erkannt. In Verbindung mit vorbekannten Ansätzen zur (automatischen) Erkennung unterschiedlicher Zeitzeichensender ist darüber hinaus eine einfache Anpassung an unterschiedliche Protokolle (Länder) möglich. Außerdem ermöglicht der erfindungsgemäße Ansatz in einfacher Weise eine Kompensation von Fertigungstoleranzen der verschiedenen Bausteine der beschriebenen Schaltungsanordnung.

### Bezugszeichenliste

- 1: Funkuhr
- 2: Zeitzeichensender
- 3: Empfangsantenne
- 4: Schaltungsanordnung
- 5: Anzeigeeinheit
- 6: Eingang
- 7: Regelverstärker
- 8: Filter
- 9: Nachverstärker
- 10: Gleichrichter
- 11: Knoten
- 12: Kondensator
- 13: Spannungsspitzen-Detektor
- 14: Kondensator
- 15: Komparator
- 16: Spannungsquelle
- 17: Transistor
- 18: Transistor
- 19: Knoten
- 20: Widerstand
- 21: Ausgang
- 22: Auswerteeinheit
- 22a: Vergleichseinrichtung
- 22b: Recheneinheit
- 23: Zähler
- 24: Speichereinrichtung

- A: Codierungsschema
- A1: Ankündigungsbits für Übergang MEZ nach MESZ
- A2: Ankündigungsbits für Schaltsekunde
- AB: Absenkung des Analogsignals
- AGC: Verstärkungs-Regelsignal
- AS: Analogsignal
- B: allgemeine Codierungsbits
- C: allgemeine Datums- und Uhrzeitinformationen
- D: Minutenbits
- DS: Digitalsignal
- E: Stundenbits
- F: Kalendertagbits
- G: Wochentagbits
- H: Kalendermonatsbits
- I: Kalenderjahrbits
- KS: Komparatorschwel le
- M: Minutenmarke
- P1, P2, P3: Prüfbits
- R: Antennenbit
- S: Startbit der codierten Zeitinformation
- SW: Sollwert
- T: Zeitdauer
- VCC: Betriebsspannung
- X: Zeitzeichensignal
- X1, X2: Absenkungen des Zeitzeichensignals
- Z1, Z2: Zonenzeitbits

## Patentansprüche

1. Verfahren zur Gewinnung von Zeitinformationen aus einem empfangenen, amplitudenmodulierten Zeitzeichensignal (X), wobei das Zeitzeichensignal (X) demoduliert, das erhaltene Analogsignal (AS) mittels eines Komparators (15) digitalisiert und das erhaltene Digitalsignal (DS) zur Gewinnung der Zeitinformationen ausgewertet wird,
**dadurch gekennzeichnet, dass**
• ein Kennwert der zeitlichen Dauer (T) wenigstens einer Signalphase eines bestimmten Signalpegels (Low) des Digitalsignals (DS) mit einem Sollwert (SW) vergleichen wird und dass
• eine Komparatorschwelle (KS) des Komparators (15) in Abhängigkeit von einem Ergebnis des Vergleichs verändert wird, sodass die zeitliche Dauer (T) zumindest der betreffenden Signalphase (Low) des Digitalsignals (DS) sich an den Sollwert (SW) annähert.

2. Verfahren nach Anspruch 1, **dadurch gekennzeichnet, dass** die zeitliche Dauer (T) einer Low-Phase (Low) des Digitalsignals (DS) mit einem Sollwert (SW) verglichen wird.

3. Verfahren nach Anspruch 1 oder 2, **dadurch gekennzeichnet, dass** die Veränderung der Komparatorschwelle (KS) stufenweise erfolgt.

4. Verfahren nach einem der Ansprüche 1 bis 3, **dadurch gekennzeichnet, dass** für den Vergleich ein Mittelwert aus einer Mehrzahl von zeitlichen Dauern (T) der betreffenden Signalphase (Low) des Digitalsignals (DS) gebildet wird.

5. Verfahren nach einem der Ansprüche 1 bis 4, **dadurch gekennzeichnet, dass** der Sollwert (SW) in Abhängigkeit von einem das Zeitzeichensignal (X) aussendenden Zeitzeichensender (2) bestimmt wird.

6. Schaltungsanordnung (4) zum Empfangen und zur Gewinnung von Zeitinformationen aus von einem Zeitzeichensender (2) gesendeten, amplitudenmodulierten Zeitzeichensignalen (X), insbesondere zur Durchführung eines Verfahrens nach einem der vorangehenden Ansprüche, mit einem Demodulator (12) zum Demodulieren des Zeitzeichensignals (X) und zum Erzeugen eines Analogsignals (AS) aus dem Zeitzeichensignal (X), einem Komparator (15) zum Digitalisieren des erhaltenen Analogsignals (AS) und einer Auswerteeinheit (22) für das erhaltene Digitalsignal (DS) zur Gewinnung der Zeitinformationen,
**gekennzeichnet durch**
• eine Speichereinrichtung (24), in der zumindest ein Sollwert (SW) für die zeitliche Dauer (T) wenigstens einer Signalphase des Zeitzeichensignals (X) hinterlegt ist,
• eine Vergleichseinrichtung (22a) in Wirkverbindung mit der Speichereinrichtung (24), die zum Vergleichen eines Kennwerts der zeitlichen Dauer (T) wenigstens einer Signalphase eines bestimmten Signalpegels (Low) des Digitalsignals (DS) mit dem Sollwert (SW) ausgebildet ist, und
• eine Änderungseinrichtung (16, 22) in Wirkverbindung mit der Vergleichseinrichtung (22a), die zum Verändern einer Komparatorschwelle (KS) des Komparators (15) in Abhängigkeit von einem Ergebnis des Vergleichs in der Vergleichseinrichtung (22a) ausgebildet ist, sodass die zeitliche Dauer (T) zumindest der betreffenden Signalphase (Low) des Digitalsignals (DS) an den Sollwert (SW) anpassbar ist.

7. Schaltungsanordnung (4) nach Abspruch 6, **dadurch gekennzeichnet, dass** der Sollwert (SW) die zeitliche Dauer einer Amplitudenabsenkung (X1, X2) des Zeitzeichensignals (X) ist.

8. Schaltungsanordnung (4) nach Anspruch 6 oder 7, **dadurch gekennzeichnet, dass** die Auswerteeinheit (22) zum Erkennen des Zeitzeichensenders (2) aus einer Mehrzahl von Zeitzeichensendern (2) ausgebildet ist und dass in Abhängigkeit von dem erkannten Zeitzeichensender (2) ein entsprechender Sollwert (SW) aus der Speichereinrichtung (24) in der Vergleichseinrichtung (22a) bereitstellbar ist.

9. Schaltungsanordnung (4) nach einem der Ansprüche 6 bis 8, **dadurch gekennzeichnet, dass** die Änderungseinrichtung (16, 22) zum stufenweisen Verändern der Komparatorschwelle (KS) ausgebildet ist.

10. Schaltungsanordnung (4) nach einem der Ansprüche 6 bis 9, **gekennzeichnet durch** eine Recheneinheit (22b) in Wirkverbindung mit der Vergleichseinrichtung (22a), die zum Bestimmen des Mittelwerts aus einer Anzahl von zeitlichen Dauern (T) der betreffenden Signalphase (Low) des Digitalsignals (DS) und zum Bereitstellen des Mittelwerts in der Vergleichseinrichtung (22a) als Kennwert ausgebildet ist.

11. Funkuhr (1), **gekennzeichnet durch** eine Schaltungsanordnung (4) nach einem der Ansprüche 6 bis 10.
